# EUROPÄISCHE PATENTSCHRIFT

(11) **EP 0 301 604 B1**
(45) Veröffentlichungstag und Bekanntmachung des Hinweises auf die Patenterteilung: **26.05.1993**
(21) Anmeldenummer: 88113029.8
(22) Anmeldetag: 21.01.1985
(51) Int. Cl.: C23C 14/34, C23C 16/50, H01J 37/32

(54) **Vorrichtung zur Beschichtung eines Substrates mittels Plasma-Chemical Vapour Deposition oder Kathodenzerstäubung und damit ausgeführtes Verfahren**
Apparatus for coating a substrate by plasma-chemical vapour deposition or cathodic sputtering, and process using the apparatus
Dispositif pour le revêtement d'un substrat par dépôt chimique en phase vapeur avec un plasma ou par pulvérisation cathodique et procédé utilisant ce dispositif

(30) Priorität: 30.01.1984 DE 3403042; 28.01.1984 DE 3402971
(43) Veröffentlichungstag der Anmeldung: 01.02.1989
(62) Teilanmeldung aus: 85200054.6
(73) Patentinhaber: Philips Patentverwaltung GmbH, 22335 Hamburg (DE); Philips Electronics N.V., 5621 BA Eindhoven (NL)
(72) Erfinder: Bringmann, Udo, D-2083 Halstenbek (DE); Drews, Klaus, D-2083 Halstenbek (DE); Schön, Detlef Gerd, Dr., D-2083 Halstenbek (DE); Dössel, Olaf Helmut, Dr., D-2086 Ellerau (DE); Gerstenberg, Klaus Wolfgang, Dr., D-2083 Halstenbek (DE); Kürsten, Gerhard, D-2000 Hamburg 61 (DE); Orlowski, Reiner Uwe, Dr., D-2085 Quickborn (DE)
(74) Vertreter: Kupfermann, Fritz-Joachim, Dipl.-Ing.

(56) Entgegenhaltungen:
- FR-A- 2 339 001
- US-A- 3 748 253
- PATENT ABSTRACTS OF JAPAN, Band 5, Nr. 109 (E-65)[781], 15. Juli 1981; & JP-A-56 49 521 8
- PATENT ABSTRACTS OF JAPAN, Band 7, Nr. 13, (E-153)[1158], 19. Januar 1983; & JP-A-57 172 741
- IBM TECHNICAL DISCLOSURE BULLETIN, Band 26, Nr. 2, Juli 1983, Seite 588, New York, US; B.L. RATHBUN et al.: "Passivating coating"

## Beschreibung

Die Erfindung betrifft eine Vorrichtung, die zur Beschichtung eines Substrates sowohl mittels Plasma-Chemical Vapour Deposition als auch mittels HF-Kathodenzerstäubung geeinget ist, mit
- einer evakuierbaren Kammer,
- einer in axialer Richtung der Kammer feststehenden Ringelektrode mit einer zentralen Bohrung,
- einer als Plattenelektrode ausgebildeten Gegenelektrode,
- Einrichtungen zur Einführung gasförmiger Substanzen in den die Elektroden umgebenden Reaktionsraum der Kammer,
- Einrichtungen zum Anlegen einer Spannung an die Ringelektrode und/oder Gegenelektrode zur Erzeugung eines Plasmas, und
- die Ringelektrode und die Gegenelektrode zentrisch in der Kammer angeordnet sind.

Aus der FR-2 339 001 ist eine entsprechende Vorrichtung zur Beschichtung eines Substrats bekannt, das ebenfalls eine in axialer Richtung der Kammer feststehende Ringelektrode und eine als Plattenelektrode ausgebildete Gegenelektrode aufweist. Ferner ist aus "Patent Abstracts of Japan", Band 5, Nr. 109 (E-65) [781], 15. Juli 1981 & JP-A-56 49 521 eine Vorrichtung zur Beschichtung eines Substrats mit einer in axialer Richtung der Kammer feststehenden Ringelektrode und einer als Plattenelektrode ausgebildeten Gegenelektrode bekannt, wobei die Reaktionsgase in der zentralen Bohrung der Ringelektrode eingelassen werden und die Ringelektrode derart über dem Anschlußstutzen für die Vakuumpumpe aufliegt, daß der Anschlußstutzen frei bleibt.

Eine derartige Anlage ist beispielsweise einsetzbar zur Beschichtung eines Substrats mit einer Schicht aus polymerisiertem Material durch eine Glimmentladungs-Polymerisation oder auch als Anlage für einen HF-Kathodenzerstäubungsprozeß.

Glimmentladungs-Polymerisation ist eine bekannte Technik zur Abscheidung einer Lage eines organischen oder anorganischen Polymers. Es gibt zwei grundlegende Arten von Verfahren.

Bei der ersten Art wird die Oberfläche eines existierenden Materials polymerisiert und ausgehärtet, in dem sie einer Glimmentladung ausgesetzt wird, die in Luft oder einem inerten Gas erzeugt wird. Durch die Glimmentladung werden Oberflächenmoleküle aktiviert und bilden Verbindungen und Querverbindungen mit benachbarten Molekülen. Da die Aktivierung auf einen Bereich in der Nähe der Oberfläche begrenzt ist, bleibt die Masse des Materials unverändert.

Bei der zweiten Art von Verfahren wird eine Lage polymerisierten Materials auf einem Substrat abgeschieden, indem eine Glimmentladung in einem monomeren Gas, angrenzend an das Substrat, betrieben wird. Reaktionsfreudige Spezies bzw. Materialarten, die in der Glimmentladung erzeugt werden, scheiden sich auf dem Substrat ab und bilden eine polymerisierte Schicht. Die Polymerisierung erstreckt sich durch das gesamte abgeschiedene Material. Die vorliegende Vorrichtung betrifft die Durchführung von Polymerisationsverfahren nach der zweiten Art.

Bei einer typischen Polymerisations-Situation der zweiten Art wird die Glimmentladung dadurch errichtet, daß ein elektrisches Potential an zwei Elektroden angelegt wird, die in einer Kammer vorgesehen sind, welche ein monomeres Gas bei einem Druck von weniger als dem Atmosphärendruck enthält. Dabei tritt keine Glimmentladung auf und es fließt nur ein sehr kleiner Strom durch das Gas, wenn nicht das Potential zwischen den Elektroden einen Schwellwert überschreitet, der ausreichend ist, um das Gas zu ionisieren oder zum Durchbruch zu bringen.

Es ist bekannt, daß dieses Durchbruchspotential von der Zusammensetzung des Gases, dem Systemdruck und dem Abstand zwischen den Elektroden abhängt. Nachdem der Durchbruch erfolgt ist, ist das Gas leitend und ein stabiles Plasma kann über einen weiten Bereich von Strömen aufrechterhalten werden. Ein einmal errichtetes Plasma kann mit einem Potential aufrechterhalten werden, das kleiner ist als das Durchbruchspotential bzw. die Durchbruchsspannung. Die genaue Zusammensetzung des Entladungsplasmas ist nicht bekannt.

Es wird angenommen, daß es aus Elektronen, Ionen, freien Radikalen und anderen reaktionsfreudigen Spezies besteht.

HF-Kathodenzerstäubung ist ebenfalls ein bekanntes Verfahren zur Bildung einer Materialschicht auf einem Substrat.

Bei der Kathodenzerstäubung (Sputtern) wird das Material von der Oberfläche einer Auftreffplatte (Target) durch Ionenbombardement entfernt und auf dem Substrat abgelagert. Wenn das zu zerstäubende Material ein elektrischer Leiter ist, wird ein Gleichspannungspotential verwendet. Wenn das zu zerstäubende Material ein Nichtleiter bzw. ein Isolator ist, ist es bevorzugt, eine Hochfrequenzspannung zu verwenden, um den Aufbau von Oberflächenladungen auf dem Isolator und den sich daraus ergebenden Verlust an Beschleunigungsspannung zu vermeiden. Bei bekannten Verfahren zur Abscheidung einer Schicht eines Polymers durch Kathodenzerstäubung wird zuerst das Polymer selbst in der Form einer Platte bzw. einer Tafel oder eines Pulvertargets vorbereitet. Eine Auftreffelektrode wird hergestellt durch Anordnung des Targets in Kontakt mit einer leitenden Oberfläche. Die Auftreffelektrode bzw. das Target und eine zweite Elektrode werden in einer evakuierten Kammer angeordnet, die mit einem ionisierbaren inerten Gas, beispielsweise Argon, bei einem geeigneten Druck gefüllt werden kann. Eine polymere Schicht auf einem Substrat kann dadurch gebildet werden, daß eine Glimmentladung errichtet wird, in dem eine geeignete Spannung zwischen dem Target und der zweiten Elektrode angelegt wird.

Der Erfindung liegt die Aufgabe zugrunde, eine Vorrichtung der eingangs genannten Art zu schaffen, die sowohl für die Abscheidung von Schichten mittels eines Plasma-Chemical Vapour Deposition-Prozesses als auch mittels eines HF-Kathodenzerstäubungsprozesses einsetzbar ist, die eine große Variabilität der Prozeßführung gestattet, die sich also leicht auf unterschiedliche gewünschte Prozeßführungen umrüsten läßt, die leicht demontierbar ist, die sich einfach reinigen läßt und die eine besonders gute Homogenität der Dicke der herzustellenden Schichten gewährleistet.

Diese Aufgabe wird erfindungsgemäß dadurch gelöst, daß
- die Ringelektrode und die Gegenelektrode zentrisch in der Kammer angeordnet sind,
- die Ringelektrode auf einem zweigeteilten Isolatorblock angeordnet ist mit einem oberen ersten Teil, der an die Ringelektrode angrenzt und mit einer der zentralen Bohrung der Ringelektrode entsprechenden zentralen Bohrung versehen ist, und mit einem zweiten Teil, der an den ersten Teil unmittelbar angrenzt und auf der Bodenplatte der evakuierten Kammer so über einem Anschlußstutzen der für die Evakuierung der Kammer erforderlichen Vakuumpumpe aufliegt, daß der Anschlußstutzen frei bleibt, und
- der erste Teil des Isolatorblocks mit mindestens einer in die zentrale Bohrung mündenden und etwa senkrecht zu dieser sich erstreckenden, verschließbaren weiteren Bohrung versehen ist.

Erfindungsgemäß ist somit der erste Teil des Isolatorblockes mit mindestens einer in die zentrale Bohrung mündenden und etwa senkrecht zu dieser sich erstreckenden weiteren Bohrung versehen. Hiermit ist der Vorteil verbunden, daß die Vorrichtung sehr schnell umrüstbar ist in bezug auf unterschiedliche Einrichtungen zur Einführung gasförmiger Substanzen.

Eine besondere gute Variabilität der Prozeßführung wird dadurch erreicht, daß die Einrichtung zur Einführung gasförmiger Substanzen nach zwei unterschiedlichen Prinzipien arbeiten kann. Nach vorteilhaften Weiterbildungen der Erfindung ist die Einrichtung zur Einführung gasförmiger Substanzen in die evakuierbare Kammer ein Mehrkammerringverteiler, in den von außen Reaktionsgase einspeisbar sind, die frei in den Reaktionsraum der Kammer gelangen. Die Einrichtung zur Einführung gasförmiger Substanzen in die evakuierbare Kammer kann auch durch in die evakuierbare Kammer vakuumdicht hineingeführte Gaszuleitungen realisiert sein, die in die in die zentrale Bohrung des Isolatorblockes mündende, senkrecht zu ihr verlaufende weitere Bohrung einmünden.

Mit der Einleitung der gasförmigen Substanzen über den Mehrkammerringverteiler ist der Vorteil verbunden, daß eine sehr gute Homogenisierung der Gasströmung gewährleistet ist, was zu einer außerordentlich guten Gleichmäßigkeit der Schichtdicke der erzeugten Schichten führt. Mit dieser Gasführung und der Möglichkeit der Einstellbarkeit der Höhe des Mehrkammerringverteilers, derart, daß der Abstand zwischen der Ringelektrode und den Gasaustrittsöffnungen im Mehrkammerringverteiler möglichst gering gehalten wird, ist der weitere Vorteil verbunden, daß die Verschmutzung des Reaktors sehr gering bleibt. Diese Art der Gasführung ist besonders geeignet, wenn bei höheren Gasdrucken und damit höheren Strömungsgeschwindigkeiten gearbeitet werden soll, also immer dann, wenn eine Verarmung der angeregten Spezies infolge erhöhter Abscheidungsrate auftritt und der damit sich einstellende Schichtdickengradient vermieden werden soll.

Mit der Gasführung über die Einleitung der gasförmigen Substanzen unmittelbar in die zentrale Bohrung im zweigeteilten Isolatorblock unterhalb der Ringelektrode ist der Vorteil verbunden, daß sehr homogene Schichten erreichbar sind, falls keine Verarmungseffekte der aktivierten Spezies radial nach außen auftreten.

Nach weiteren vorteilhaften Weiterbildungen der Erfindung sind auf einer oder beiden Elektroden, also auf der Ringelektrode und/oder auf der ihr gegenüberliegenden Plattenelektrode, Drehteller vorgesehen, derart, daß sie drehbar sind durch ein mit der(den) Elektrode(n) fest verbundenes Zahnrad, das über ein elektrisch isolierendes Zwischenstück und mindestens eine von außen vakuumdicht in die evakuierbare Kammer hineingeführte Drehdurchführung antreibbar ist.

Nach weiteren vorteilhaften Weiterbildungen der Erfindung ist sowohl in der Ringelektrode als auch in der Plattenelektrode ein Temperierlabyrinthsystem vorgesehen, das über einen lösbaren Anschlußflansch mit einem Temperiermedienkreislauf verbunden ist. Hiermit ist der Vorteil verbunden, daß die Abscheidungsrate über die Temperatur beeinflußbar ist.

Nach weiteren vorteilhaften Weiterbildungen der Erfindung sind sowohl auf die Ringelektrode als auch auf die Plattenelektrode widerstandsbeheizte Platten als Zusatzheizung aufsetzbar, bei denen die Heizstromübertragung mittels Schleifringkontakten erfolgt. Hiermit ist der Vorteil verbunden, daß auch Prozesse durchführbar sind, bei denen eine bestimmte Substrat-Mindesttemperatur erforderlich ist.

Soll die erfindungsgemäße Vorrichtung für einen Hochfrequenz-Kathodenzerstäubungsprozeß eingesetzt werden, sind nach einer vorteilhaften weiteren Ausgestaltung der Erfindung die Elektroden (Ring- und Plattenelektrode) mit an Massepotential liegenden Abschirmungen versehbar. Die Durchführung eines Plasma-Chemical Vapour Deposition-Prozesses mit der Vorrichtung gemäß der Erfindung wird an einem Beispiel für die Herstellung einer plasmapolymerisierten Schicht auf einem Substrat beschrieben, wobei so verfahren wird, daß auf einer der Elektroden (Plattenelektrode oder Ringelektrode) in der evakuierbaren Kammer mindestens ein zu beschichtendes Substrat aufgelegt und daß in die Kammer über die Einrichtung zur Einführung gasförmiger Substanzen ein Ausgangsgas, bestehend aus mindestens einem monomeren Prozeßgas, aus dem eine Schicht aus plasmapolymerisiertem Material durch Hochfrequenz-Anregung der Gasphasenmoleküle auf dem(den) Substrat(en) abscheidbar ist, und gegebenenfalls mindestens einem inerten Trägergas, eingeführt wird. Nach einer vorteilhaften Weiterbildung des Verfahrens gemäß der Erfindung wird die Schicht aus plasmapolymerisiertem Material derart gebildet, daß als monomeres Prozeßgas mindestens ein solches Gas eingespeist wird, aus dem polymerisierte Si:N:C:H-haltige Verbindungen gebildet werden können. Vorzugsweise wird als monomeres Prozeßgas Hexamethyldisilazan eingespeist.

Anhand der Zeichnung werden Ausführungsbeispiele der Erfindung beschrieben und in ihrer Wirkungsweise erläutert. Es zeigen:
- Fig. 1: Vorrichtung gemäß der Erfindung im Schnitt mit einer Gaszuführung über einen Mehrkammerringverteiler.
- Fig. 2: Vorrichtung gemäß der Erfindung im Schnitt mit Gaszuführung unmittelbar in die zentrale Bohrung im Isolatorblock unterhalb der Ringelektrode.
- Fig. 3: Vorrichtung gemäß der Erfindung im Schnitt zur Anwendung als HF-Kathodenzerstäubungsanlage.

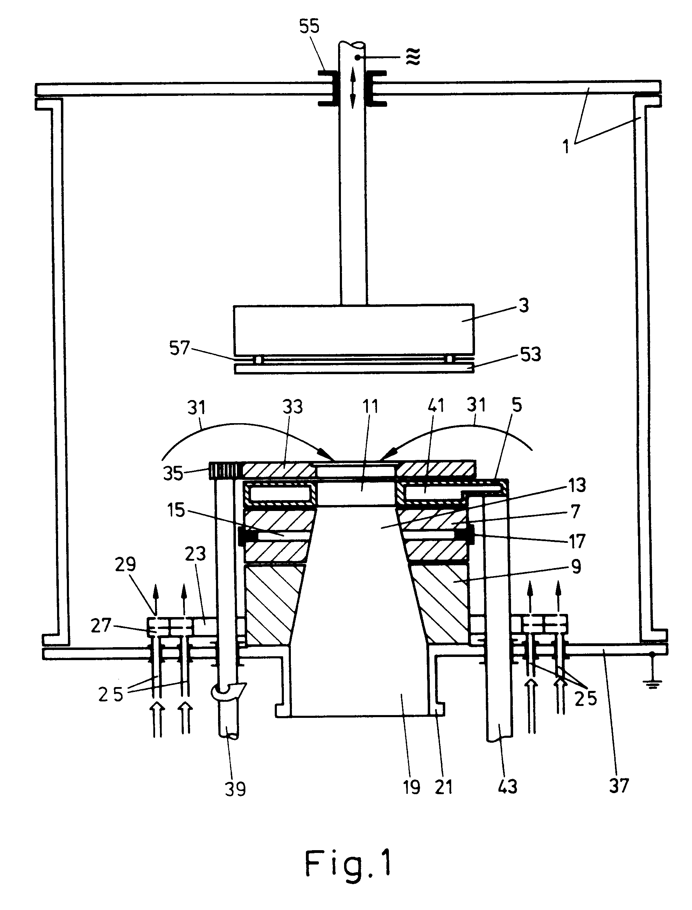

In Figur 1 ist eine Vorrichtung zur Beschichtung eines Substrates mit einer evakuierbaren Kammer 1 dargestellt mit einer Plattenelektrode 3 und einer Ringelektrode 5, die auf einem zweigeteilten Isolatorblock aufliegt. Die Ringelektrode 5 hat eine zentrale Bohrung 11. Der unterhalb der Ringelektrode angeordnete Isolatorblock weist einen ersten oberen, an die Ringelektrode angrenzenden Teil 7 auf, der mit einer zentralen, vorzugsweise sich konisch erweiternden Bohrung 13 versehen ist, deren an die Ringelektrode 5 angrenzender Durchmesser dem Durchmesser der zentralen Bohrung 11 in der Ringelektrode 5 entspricht. Der Teil 7 des Isolatorblocks weist eine in die zentrale Bohrung 13 einmündende, etwa senkrecht zu ihr verlaufende weitere Bohrung 15 auf, die verschließbar ist über Verschlußstopfen 17. Der Teil 7 des Isolatorblocks liegt auf einem zweiten Teil 9 des Isolatorblocks auf, der ebenfalls eine zentrale, vorzugsweise sich konisch erweiternde Bohrung 19 aufweist, deren an den ersten Teil des Isolatorblocks angrenzender Durchmesser dem Durchmesser der zentralen Bohrung im ersten Teil 7 des Isolatorblocks an dieser Stelle entspricht. Über den aus den zentralen Bohrungen 11, 13 und 19 gebildeten Kanal sind Gase aus dem Reaktionsraum über eine an einen Pumpstutzen 21 angeschlossene Vakuumpumpe (nicht dargestellt) absaugbar. In die evakuierbare Kammer 1 werden Prozeßgase eingespeist über einen Mehrkammerringverteiler 23; die Gase treten aus dem Mehrkammerringverteiler 23 in Pfeilrichtung frei aus in den Reaktionsraum. Der Mehrkammerringverteiler 23 weist mindestens einen Anschluß 25 für den Eintritt von Prozeßgasen auf (in der Zeichnung sind vier Anschlußstutzen dargestellt), von dem(denen) die Prozeßgase über Bohrungen in über den Anschlüssen 25 liegende, miteinander in Verbindung stehende Kammern 27 gelangen, von denen aus die Prozeßgase über eine Vielzahl von kleineren Bohrungen 29 in den Reaktionsraum gelangen und über das System der Bohrungen 11, 13 und 19 entsprechend der Richtung der Pfeile 31 aus dem Reaktionsraum wieder absaugbar sind.

Damit werden die Gase gleichmäßig verteilt über die Elektrodenoberfläche der Ringelektrode 5 zentral abgesaugt. Auf der Ringelektrode 5 ist ein Drehteller 33 angeordnet, der drehbar ist durch ein mit der Ringelektrode 5 fest verbundenes Zahnrad 35, in das ein nicht dargestelltes Ritzel eingreift, das über ein elektrisch isolierendes, versatzausgleichendes Zwischenstück und eine von außen vakuumdicht durch die Bodenplatte 37 der Kammer 1 hindurchgeführte und von außen betätigbare Drehdurchführung 39 antreibbar ist.

Aufbau des auf der Ringelektrode befindlichen Drehtellers:
Das Zahnrad 35 mit z = 360 und m = 1 (z = Zähne;
m = Modul), das mit einem Ansatz (nicht dargestellt) eines Durchmessers von 160 x 20 mm und einer Zentralbohrung eines Durchmessers von 150 mm versehen ist, wird durch einfaches Aufstecken auf die Ringelektrode 5 montiert. Der Antrieb erfolgt über ein seitlich an der Elektrode montiertes Ritzel mit z = 20, das über ein isolierendes und versatzausgleichendes Zwischenstück und die Drehdurchführung 39 von außen angetrieben wird.

Die maximale Drehzahl liegt bei etwa 2 U/min. Die Ringelektrode 5 besitzt ein Temperierlabyrinth 41, das über einen seitlichen, schnell lösbaren Anschlußflansch 43 mit einem Temperiermedienkreislauf verbindbar ist. Der Anschlußflansch 43 dient gleichzeitig als Verbindung zum HF-Generatorsystem und ist vakuumdicht und elektrisch isoliert über die Bodenplatte 37 aus der evakuierbaren Kammer 1 herausgeführt.

Um eine gute Wärmekopplung zur temperierten Ringelektrode 5 zu gewährleisten, ist als Werkstoffpaarung der Gleitflächen Bronze und Hartchrom eingesetzt. Silikonöl verbessert die thermische Kontaktnahme und die Gleiteigenschaft. Es kann auch auf der Plattenelektrode 3 ein Drehteller angeordnet werden (nicht dargestellt). Konstruktiv ist der Drehteller der oberen Plattenelektrode 3 wie der der unteren Ringelektrode 5 aufgebaut.

Infolge der hängenden Anordnung der Plattenelektrode 3 muß die Lagerung formschlüssig aufgebaut sein; dazu kann ein an der prozeßabgewandten Seite konischer Laufring am Umfang der hängenden Plattenelektrode 3 aufgesetzt sein. Auf diesen Ring können sich radial wie axial Laufrollenböcke abstützen, die auf dem Drehteller montiert sind und ihn mit seiner Planfläche gegen die Oberfläche der ebenfalls über ein Temperierlabyrinth temperierbaren Plattenelektrode 3 platzieren, so daß einerseits eine gute Wärmeleitung stattfindet und andererseits die Rotation nicht behindert wird. Die Werkstoffpaarung der Laufflächen ist auch hier Bronze auf Hartchrom, ebenfalls kann Silikonöl die Gleiteigenschaften und die Wärmeleitung verbessern.

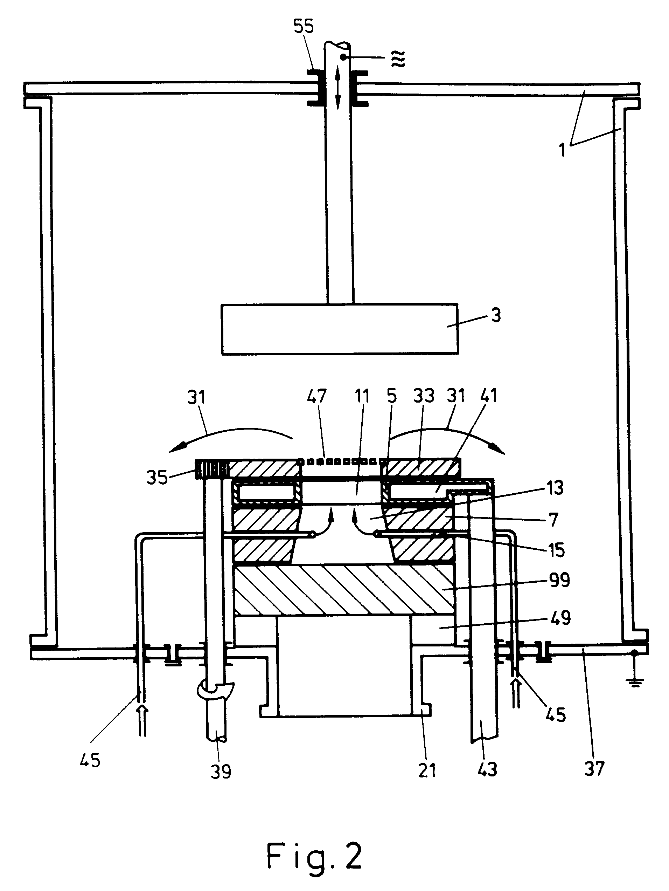

Gemäß Figur 2 ist eine abgewandelte Ausführung der Vorrichtung gemäß der Erfindung dargestellt, bei der Prozeßgase in die evakuierbare Kammer 1 eingespeist werden über durch die Bodenplatte 37 der evakuierbaren Kammer 1 vakuumdicht hindurchgeführte Gaszuleitungen 45, die in die, in die zentrale Bohrung 13 des Teils 7 des Isolatorblocks einmündende weitere Bohrung 15, von der die Verschlußstopfen 17 entfernt sind, einmünden. Für die Ausgestaltung der Vorrichtung nach Figur 2 ist der zweite Teil 99 des Isolatorblocks eine massive Platte und der an den Reaktionsraum angrenzende Bereich der zentralen Bohrung 11 in der Ringelektrode 5 ist mit einer perforierten Abdeckplatte 47, z.B. aus Kupferblech, abgedeckt. Die über die zentrale Bohrung 13 im Teil 7 des Isolatorblocks und die perforierte Abdeckplatte 47 in den Reaktionsraum gelangten Reaktionsgase werden bei diesem Ausführungsbeispiel nicht über das zentrale System aus den Bohrungen 11, 13 und 19 von der Vakuumpumpe abgesaugt, sondern sie werden außen am Teil 99 des Isolatorblockes über seitlich in ihm angebrachte Schlitze 49, deren additiver Querschnitt größer als der Querschnitt des Anschlußstutzens 21 der Vakuumpumpe ist, vom Pumpsystem abgesaugt.

Die Teilung des Isolatorblocks in die Teile 7, 9 und 99 ermöglicht also zwei Betriebsformen der Vorrichtung:
Gemäß Figur 1 ist im Isolatorblock die zentrale Bohrung frei, so daß das Pumpsystem die über den Gasverteilerring eingespeisten Gase aus dem Reaktionsraum durch diese Bohrung absaugt.
Gemäß Figur 2 ist die zentrale Absaugung unterbrochen. Die Prozeßgase strömen durch die vorhandenen Bohrungen im oberen Isolatorteil und gelangen durch das perforierte Abdeckblech zentral in den Reaktionsraum. Sie werden über die Elektrode von innen nach außen und durch seitlich angebrachte Schlitze im unteren ausgetauschten Isolatorteil in Form einer Platte ohne zentrale Bohrung von dem Pumpsystem abgesaugt.

Die Anordnung von Substraten kann auf beiden Elektroden erfolgen. Beide Elektroden sind elektrisch auf HF-Potential oder Massepotential schaltbar. Das Positionieren erfolgt durch einfaches Ablegen auf der Ringelektrode, während für die Positionierung auf der oberen Plattenelektrode eine Substrathalteplatte erforderlich ist. Beide Elektroden sind mit Drehtellern ausrüstbar, die eine gute Schichtdickenhomogenität ermöglichen.

Bei Depositionsbedingungen, die eine Temperatur bis 500 °C erfordern, kann als weiteres Zusatzelement eine Heizplatte sowohl auf die untere Ringelektrode 5 als auch auf die obere Plattenelektrode 3 in Form einer widerstandsbeheizten Platte 51 aufgesetzt werden. Die Heizstromübertragung erfolgt vermittels abgeschatteter Schleifringkontakte.

Zur thermischen Trennung sind vorteilhafterweise zwischen den Drehtellern 33 und den widerstandsbeheizten Platten 53 Strahlungsbleche 57 montiert. Substrate werden in diesem Fall auf den widerstandsbeheizten Platten platziert.

Unter Anwendung der erfindungsgemäßen Vorrichtung gemäß Figur 1 wurden aus Hexamethyldisilazan (HMDSN) hergestellte Polymerschichten auf Substraten abgeschieden. Derartige Schichten sind mit Vorteil einsetzbar als elektrisch isolierende Schichten in Dünnfilm-Dehnungsmeßstreifen, als Isolierung von Spulendrähten oder Spulenbändern oder als Isolierung von Kondensatoren insbesondere für Hochtemperaturanwendungen bei Spannungen von 1000 V. Die nach dem beschriebenen Ausführungsbeispiel abgeschiedenen Schichten erreichten bei einer Schichtdicke von d = 0,6 µm eine radiale Schichtdickenhomogenität von ± 1% bei einer betrachteten Länge von l = 60 mm;
eine radiale Schichtdickenhomogenität von ± 5% wurde bei einer betrachteten Länge von l = 140 mm erreicht.
Es wurde mit folgenden Prozeßparametern gearbeitet:
Die Substrate wurden auf der oberen Plattenelektrode 3 angebracht; der Elektrodenabstand H zwischen der Plattenelektrode 3 und der Ringelektrode 5 wurde auf H = 50 mm eingestellt; Substrattemperatur T_{S} = 35 °C; Monomergasdruck p_{HMDSN} = 2 Pa; Trägergasdruck p_{Argon} = 3 Pa; Leistungsflächendichte N = 0,5 W/cm²; Abscheidungsrate d = 40 nm/min.
Dieses Ausführungsbeispiel zeigt, daß mit der vorliegenden Vorrichtung eine besonders gute Gleichmäßigkeit der Schichtdicke der erzeugten Schichten erreichbar ist. Trotz einer erhöhten Abscheidungsrate, bei der üblicherweise durch die Verarmung der angeregten Spezies ein Schichtdickengradient auftritt, wurden die oben angegebenen guten Werte für die Schichtdickenhomogenität erreicht.

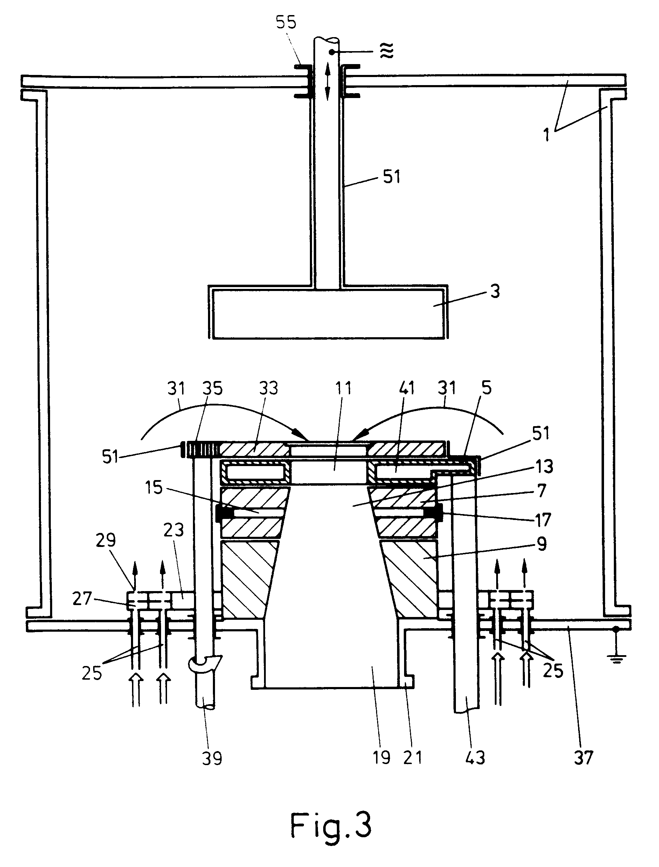

In Figur 3 ist eine Vorrichtung gemäß der Erfindung zur Anwendung als HF-Kathodenzerstäubungsanlage dargestellt. Zu diesem Zweck ist es erforderlich, die Elektroden 3, 5 gegenüber der Innenwand der evakuierbaren Kammer 1 durch zwei auf Massepotential liegende Abschirmringe 51 abzuschirmen.
- 1: Evakuierbare Kammer
- 3: Plattenelektrode
- 5: Ringelektrode
- 7: oberer Teil des Isolatorblockes
- 9,99: unterer Teil des Isolatorblockes
- 11: Bohrung in 5
- 13: Bohrung in 7
- 15: weitere Bohrung in 7,
senkrecht zu 13
- 17: Verschlußstopfen in 15
- 19: Bohrung in 9
- 21: Anschlußstutzen der Vakuumpumpe
- 23: Mehrkammerringverteiler
- 25: Anschluß in 23
- 27: Kammern in 23
- 29: Bohrungen in 27
- 31: Gasrichtungspfeile
- 33: Drehteller auf 5
- 35: Zahnrad
- 37: Bodenplatte der Kammer 1
- 39: Drehdurchführung
- 41: Temperierlabyrinth in 5
- 43: Anschlußflansch an 41
- 45: Gaszuleitung
- 47: perforierte Abdeckplatte
- 49: Schlitz in 99
- 51: Abschirmring
- 53: Widerstandsbeheizte Platte
- 55: Schiebedurchführung
- 57: Strahlungsblech

## Patentansprüche

1. Vorrichtung, die zur Beschichtung eines Substrates sowohl mittels Plasma-Chemical Vapour Deposition als auch mittels HF-Kathodenzerstäubung geeignet ist, mit
- einer evakuierbaren Kammer (1),
- einer in axialer Richtung der Kammer (1) feststehenden Ringelektrode (5) mit einer zentralen Bohrung (11),
- einer als Plattenelektrode ausgebildeten Gegenelektrode (3),
- Einrichtungen zur Einführung gasförmiger Substanzen in den die Elektroden (3,5) umgebenden Reaktionsraum der Kammer (1),
- Einrichtungen zum Anlegen einer Spannung an die Ringelektrode (5) und/oder Gegenelektrode (3) zur Erzeugung eines Plasmas und
- die Ringelektrode (5) und die Gegenelektrode (3) zentrisch in der Kammer angeordnet sind, dadurch gekennzeichnet, daß
- die Ringelektrode (5) auf einem zweigeteilten Isolatorblock angeordnet ist mit einem oberen ersten Teil (7), der an die Ringelektrode (5) angrenzt und mit einer der zentralen Bohrung (11) der Ringelektrode entsprechenden zentralen Bohrung (13) versehen ist, und mit einem zweiten Teil (9,99), der an den ersten Teil (7) unmittelbar angrenzt und auf der Bodenplatte (37) der evakuierbaren Kammer (1) so über einem Anschlußstutzen der für die Evakuierung der Kammer erforderlichen Vakuumpumpe aufliegt, daß der Anschlußstutzen frei bleibt, und
- der erste Teil (7) des Isolatorblocks mit mindestens einer in die zentrale Bohrung (13) mündenden und etwa senkrecht zu dieser sich erstreckenden, verschließbaren weiteren Bohrung (15) versehen ist.

2. Vorrichtung nach Anspruch 1,
dadurch gekennzeichnet,
daß der zweite Teil (9) des Isolatorblocks eine zentrale Bohrung (19) aufweist, die einen Durchmesser hat, der dem Durchmesser der zentralen Bohrung (13) des ersten Teils (7) des Isolatorblocks entspricht.

3. Vorrichtung nach Anspruch 1,
dadurch gekennzeichnet,
daß der zweite Teil (99) des Isolatorblocks eine massive Platte ist.

4. Vorrichtung nach Anspruch 1,
dadurch gekennzeichnet,
daß die zentrale Bohrung (13) des ersten Teils (7) des Isolatorblocks an seiner, an die Ringelektrode (5) angrenzenden Seite einen Durchmesser hat, der dem Durchmesser der zentralen Bohrung (11) der Ringelektrode entspricht und sich in Richtung auf den zweiten Teil (9, 99) des Isolatorblocks hin vergrößert.

5. Vorrichtung nach Anspruch 1,
dadurch gekennzeichnet,
daß der zweite Teil (9) des Isolatorblocks eine zentrale Bohrung (19) aufweist, die an der, an den ersten Teil (7) des Isolatorblocks angrenzenden Seite einen Durchmesser hat, der dem Durchmesser der zentralen Bohrung (13) des ersten Teils (7) des Isolatorblocks an dieser Seite entspricht und der sich in Richtung auf die Bodenplatte (37) der evakuierbaren Kammer (1) hin vergrößert.

6. Vorrichtung nach Anspruch 2,
dadurch gekennzeichnet,
daß die Einrichtung zur Einführung gasförmiger Substanzen in die evakuierbare Kammer (1) ein Mehrkammerringverteiler (23) ist, in den von außen Reaktionsgase einspeisbar sind, die frei in den Reaktionsraum der Kammer gelangen.

7. Vorrichtung nach den Ansprüchen 3,
dadurch gekennzeichnet,
daß die Einrichtung zur Einführung gasförmiger Substanzen in die evakuierbare Kammer (1) durch vakuumdicht in sie hineingeführte Gaszuleitungen (45) realisiert ist, die in die in die zentrale Bohrung (13) des Isolatorblocks mündende, senkrecht zu ihr verlaufende weitere Bohrung (15) einmünden.

8. Vorrichtung nach Anspruch 1,
dadurch gekennzeichnet,
daß ein Drehteller (33) auf mindestens einer der Elektroden (Plattenelektrode (3); Ringelektrode (5) vorgesehen ist, der drehbar ist durch ein mit der Elektrode fest verbundenes Zahnrad (35), das über ein elektrisch isolierendes Zwischenstück auf eine von außen vakuumdicht in die evakuierbare Kammer (1) hineingeführte Drehdurchführung (39) antreibbar ist.

9. Vorrichtung nach Anspruch 6,
dadurch gekennzeichnet,
daß der Mehrkammerringverteiler (23) mindestens einen Anschluß (25) für den Eintritt von Prozeßgasen aufweist, von dem(denen) die Prozeßgase über Bohrungen in im Mehrkammerringverteiler über dem(den) Anschluß(Anschlüssen) liegenden, miteinander in Verbindung stehenden Kammern (27) gelangen, von denen aus die Prozeßgase über eine Vielzahl von Bohrungen (29) in den über dem Mehrkammerringverteiler liegenden Reaktionsraum der evakuierbaren Kammer (1) gelangen und über die zentrale Bohrung (11) in der Ringelektrode (5) und die zentralen Bohrungen (13, 19) im Isolatorblock wieder aus der evakuierbaren Kammer absaugbar sind.

10. Vorrichtung nach Anspruch 1,
dadurch gekennzeichnet,
daß in mindestens einer der Elektroden (Plattenelektrode (3); Ringelektrode (5)) ein Temperierlabyrinthsystem (41) vorgesehen ist, das über einen lösbaren Anschlußflansch (43) mit einem Temperiermedienkreislauf verbunden ist.

11. Vorrichtung nach Anspruch 1,
dadurch gekennzeichnet,
daß ein Hochfrequenzgenerator zum Erzeugen der elektrischen Spannung vorgesehen ist mit Anschlüssen an die Ringelektrode (5) und/oder die Plattenelektrode (3).

12. Vorrichtung nach den Ansprüchen 10 und 11,
dadurch gekennzeichnet,
daß der Anschlußflansch (43) für das Temperiermedium gleichzeitig Verbindung zum Hochfrequenzgenerator ist.

13. Vorrichtung nach Anspruch 7,
dadurch gekennzeichnet,
daß die zentrale Bohrung (11) der Ringelektrode (5) auf der dem Reaktionsraum zugekehrten Seite mit einer perforierten Platte (47) abdeckbar ist, über die die Reaktionsgase in den Reaktionsraum strömen.

14. Vorrichtung nach Anspruch 1,
dadurch gekennzeichnet,
daß beide Teile (7, 9, 99) des Isolatorblocks aus einem für die Hochfrequenz-Anwendung geeigneten, elektrisch isolierenden Material bestehen.

15. Vorrichtung nach Anspruch 14,
dadurch gekennzeichnet,
daß beide Teile (7, 9, 99) des Isolatorblocks aus Polytetrafluoräthylen bestehen.

16. Vorrichtung nach Anspruch 1,
dadurch gekennzeichnet,
daß die Plattenelektrode (3) zur Verschiebung der Elektrode in axialer Richtung über einen Isolator mit einer vakuumdicht in die evakuierbare Kammer (1) hineingeführten Schiebedurchführung (55) verbunden ist.

17. Vorrichtung nach Anspruch 1,
dadurch gekennzeichnet,
daß Substrate sowohl auf der Ringelektrode (5) als auf der Plattenelektrode (3) platzierbar sind.

18. Vorrichtung nach den Ansprüchen 7 und 13,
dadurch gekennzeichnet,
daß im zweiten Teil (99) des Isolatorblocks Schlitze (49) vorgesehen sind, über die die Reaktionsgase von der Vakuumpumpe absaugbar sind.

19. Vorrichtung nach Anspruch 8,
dadurch gekennzeichnet,
daß die Gleiteigenschaften zwischen dem(den) Drehteller(n) (33) und der(den) Elektroden (Plattenelektrode (3); Ringelektrode (5)) verbessert werden durch ein gut wärmeleitfähiges Gleitmittel.

20. Vorrichtung nach Anspruch 1,
dadurch gekennzeichnet,
daß sowohl auf die Ringelektrode (5) als auch auf die Plattenelektrode (3) widerstandsbeheizte Platten (53) als Zusatzheizung aufsetzbar sind, bei denen die Heizstromübertragung mittels Schleifringkontakten erfolgt.

21. Vorrichtung nach Anspruch 20,
dadurch gekennzeichnet,
daß zwischen dem(den) Drehteller(n) (33) und der(den) widerstandsbeheizten Platte(n) (53) Strahlungsbleche (57) montierbar sind.

22. Vorrichtung nach den Ansprüchen 17 und 20,
dadurch gekennzeichnet,
daß Substrate auf den widerstandsbeheizten Platten (53) platzierbar sind.

23. Vorrichtung nach den Ansprüchen 1 bis 22,
dadurch gekennzeichnet,
daß bei Anwendung der Vorrichtung als HF-Kathodenzerstäubungsanlage die Elektroden mit an Massepotential liegenden Abschirmungen (51) versehbar sind.

24. Verfahren zur Herstellung einer plasmapolymerisierten Schicht auf einem Substrat unter Anwendung der Vorrichtung nach den Ansprüchen 1 bis 22,
dadurch gekennzeichnet,
daß auf einer der Elektroden (Plattenelektrode (3); Ringelektrode (5)) in der evakuierbaren Kammer (1) mindestens ein zu beschichtendes Substrat aufgelegt wird und daß in die Kammer über die Einrichtung zur Einführung gasförmiger Substanzen Ausgangsgas, bestehend aus mindestens einem monomeren Prozeßgas, aus dem eine Schicht aus plasmapolymerisiertem Material durch Hochfrequenz-Anregung der Gasphasenmoleküle auf dem(den) Substrat(en) abscheidbar ist, und gegebenenfalls einem inerten Trägergas, eingeführt wird.

25. Verfahren nach Anspruch 24,
dadurch gekennzeichnet,
daß die Schicht aus plasmapolymerisiertem Material derart gebildet wird, daß als monomeres Prozeßgas mindestens ein solches Gas eingespeist wird, aus dem polymerisierte Si:N:C:H-haltige Verbindungen gebildet werden können.

26. Verfahren nach Anspruch 25,
dadurch gekennzeichnet,
daß als monomeres Prozeßgas Hexamethyldisilazan eingespeist wird.

## Claims

1. A device which can suitably be used for coating a substrate by means of both plasma-chemical vapour deposition and RF cathode sputtering, comprising
- a chamber (1) which can be evacuated,
- an annular electrode (5) having a central bore (11) which is fixed in the axial direction of the chamber (1),
- a counter electrode (3) which is constructed as a plate electrode,
- apparatus for introducing gaseous substances into the reaction space of the chamber (1) surrounding the electrodes (3,5),
- apparatus for applying a voltage to the annular electrode (5) and/or counter electrode (3) to produce a plasma, and
- said annular electrode (5) and counter electrode (3) being centrally arranged in the chamber,
characterized in that
- the annular electrode (5) is provided on a bipartite insulator block having an upper first portion (7) adjoining the annular electrode (5) and having a central bore (13) corresponding to the central bore (11) of the annular electrode, and having a second portion (9, 99) directly adjoining the first portion (7) and bearing on the base plate (37) of the evacuatable chamber (1), over a connection flange of the vacuum pump required for the evacuation of the chamber, in such a manner that the connection flange is left clear, and
- the first portion (7) of the insulator block comprises at least one further bore (15) which can be closed and which opens into the central bore (13) and extends substantially perpendicularly thereto.

2. A device as claimed in Claim 1, characterized in that the second portion (9) of the insulator block comprises a central aperture (19) which has a diameter which corresponds to the diameter of the central aperture (13) of the first portion (7) of the insulator block.

3. A device as claimed in Claim 1, characterized in that the second portion (99) of the insulator block is a solid plate.

4. A device as claimed in Claim 1, characterized in that on the side adjoining the annular electrode (5), the central aperture (13) of the first portion (7) of the insulator block has a diameter which corresponds to the diameter of the central aperture (11) of the annular electrode, and widens in the direction of the second portion (9, 99) of the insulator block.

5. A device as claimed in Claim 1, characterized in that the second portion (9) of the insulator block has a central aperture (19) which on the side adjoining the first portion (7) of the insulator block has a diameter which corresponds to the diameter of the central aperture (13) of the first portion (7) of the insulator block on said side and which widens in the direction of the base plate (37) of the evacuatable chamber (1).

6. A device as claimed in Claim 2, characterized in that the apparatus for introducing gaseous substances into the evacuatable chamber (1) is a multichamber annular distributor (23) into which reaction gases can be introduced from without which can freely reach the reaction space of the chamber.

7. A device as claimed in Claim 3, characterized in that the apparatus for introducing gaseous substances into the evacuatable chamber (1) is formed by gas pipes (45) led-in in a vacuum-tight manner and opening into the further aperture (15) which opens into the central aperture (13) of the insulator block and extends at right angles thereto.

8. A device as claimed in Claim 1, characterized in that a turntable (33) is provided on at least one of the electrodes (plate electrode (3); annular electrode (5)) which can be rotated by a gearwheel (35) which is rigidly connected to the electrode and which can be driven via an electrically insulating intermediate member on a rotary lead-through (39) introduced into the evacuatable chamber (1) from without in a vacuum-tight manner.

9. A device as claimed in Claim 6, characterized in that the multichamber annular distributor (23) comprises at least one connection (25) for the inlet of process gases, through which connection(s) the process gases reach intercommunicating chambers (27) via apertures, said chambers being located in the multichamber annular distributor and being present above the connection(s), from said chambers the process gases reach via a number of apertures (29), the reaction space of the evacuatable chamber (1) present above the multi-chamber annular distributor and can be exhausted from the evacuatable chamber again via the central aperture (11) in the annular electrode (5) and the central aperture (13, 19) in the insulator block.

10. A device as claimed in Claim 1, characterized in that in at least one of the electrodes (plate electrode (3), annular electrode (5)) a tempering labyrinth system (41) is provided which is connected to a tempering agent circuit via a detachable connection flange (43).

11. A device as claimed in Claim 1, characterized in that a high frequency generator for producing the electric voltage is provided and is connected to the annular electrode (5) and/or the plate electrode (3).

12. A device as claimed in Claims 10 and 11, characterized in that the connection flange (43) for the tempering agent is also connected to the high frequency generator.

13. A device as claimed in Claim 7, characterized in that on the side facing the reaction space, the central aperture (11) of the annular electrode (5), can be covered with a perforated plate (47) via which the reaction gases flow into the reaction space.

14. A device as claimed in Claim 1, characterized in that both portions (7, 9, 99) of the insulator block consist of an electrically insulating material suitable for high frequency application.

15. A device as claimed in Claim 14, characterized in that both portions (7, 9, 99) of the insulator block consist of polytetrafluoroethylene.

16. A device as claimed in Claim 1, characterized in that the plate electrode (3) for moving the electrode in the axial direction is connected via an insulator to a sliding lead-through (55) introduced into the evacuatable chamber (1) in a vacuum-tight manner.

17. A device as claimed in Claim 1, characterized in that substrates can be placed both on the annular electrode (5) and on the plate electrode (3).

18. A device as claimed in Claims 7 and 13, characterized in that slots (49) are provided in the second portion (99) of the insulator block and via said slots the reaction gases can be exhausted by the vacuum pump.

19. A device as claimed in Claim 8, characterized in that the sliding properties between the turntable(s) (33) and the electrode(s) (plate electrode, (3); annular electrode (5)) are improved by a readily heat-conducting lubricant.

20. A device as claimed in Claim 1, characterized in that as an additional heating resistance-heated plates (53) may be provided on the annular electrode (5) and on the sheet electrode (3), the heat flow transmission occurring by sliding ring contacts.

21. A device as claimed in Claim 20, characterized in that radiation sheets (57) may be mounted between the turntable(s) (33) and the resistance-heated plate(s) (53).

22. A device as claimed in Claims 17 and 20, characterized in that substrates can be placed on the resistance-heated plates (53).

23. A device as claimed in Claim 1 to 22, characterized in that when the device is used as an RF cathode sputtering device the electrodes can be provided with screens (51) which are connected to earth.

24. A method of manufacturing a plasma-polymerized layer on a substrate by using the device as claimed in Claims 1 to 22, characterized in that at least one substrate to be coated is provided on one of the electrodes (plate electrode (3); annular electrode (5)) in the evacuatable chamber (1) and in that starting gas consisting of at least one monomeric process gas form which a layer of plasma-polymerized material can be deposited on the substrate(s) by high frequency excitation of the gas phase molecules and optionally an inert carrier gas is introduced into the chamber via the apparatus for introducing gaseous substances.

25. A method as claimed in Claim 24, characterized in that the layer of plasma-polymerized material is formed so that as a monomeric process gas at least a type of gas is introduced from which polymerized Si:N:C:H-containing compounds can be formed.

26. A method as claimed in Claim 25, characterized in that hexamethyldisilazane is used as a monomeric process gas.

## Revendications

1. Dispositif pour revêtir un substrat par dépôt chimique en phase vapeur assisté de plasma aussi bien que par pulvérisation cathodique HF, muni
- d'une chambre (1) pouvant être mise sous vide,
- d'une électrode annulaire (5) percée d'un alésage central (11), fixée en sens axial de la chambre (1),
- d'une contre-électrode (3) conçue comme électrode à plaque,
- de dispositifs pour l'admission de substances gazeuses dans l'enceinte de réaction de la chambre (1) entourant les électrodes (3, 5),
- de dispositifs pour appliquer une tension à l'électrode annulaire (5) et/ou à la contre-électrode (3) pour engendrer un plasma,
et, de ce fait, caractérisé en ce que
- l'électrode annulaire (5) et la contre-électrode sont disposées de façon centrale dans la chambre,
- l'électrode annulaire (5) est disposée sur un bloc isolateur divisé en deux présentant une première partie supérieure (7) touchant à l'électrode annulaire (5) et comportant un alésage central (13) qui correspond à l'alésage central (11) de l'électrode annulaire, ainsi que d'une seconde partie (9, 99) immédiatement contiguë à la première partie (7), qui située sur la plaque de fond (37) de la chambre (1) pouvant être mise sous vide, s'appuie sur un bourrelet de raccordement de la pompe à vide nécessaire pour la mise sous vide de la chambre, de manière que le bourrelet de raccordement reste libre et en ce que
- la première partie (7) du bloc isolateur est munie, au moins, d'un autre alésage obturable (15) débouchant dans l'alésage central (13) et s'étendant à peu près perpendiculairement à celui-ci.

2. Dispositif selon la revendication 1, caractérisé en ce que la seconde partie (9) du bloc isolateur présente un alésage central (19) ayant un diamètre qui correspond à celui de l'alésage central (13) percé dans la première partie (7) du bloc isolateur.

3. Dispositif selon la revendication 1, caractérisé en ce que la seconde partie (99) du bloc isolateur est une plaque massive.

4. Dispositif selon la revendication 1, caractérisé en ce que l'alésage central (13) de la première partie (7) du bloc isolateur présente du côté contigu à l'électrode annulaire (5) un diamètre correspondant à celui de l'alésage centrale (11) de l'électrode annulaire et qui va en s'élargissant dans la direction de la seconde partie (9, 99) du bloc isolateur.

5. Dispositif selon la revendication 1, caractérisé en ce que la seconde partie (9) du bloc isolateur présente un alésage central (19) ayant du côté contigu à la première partie (7) du bloc isolateur un diamètre correspondant à celui de l'alésage central (13) percé de ce côté dans la première partie (7) du bloc isolateur et qui va en s'élargissant dans la direction de la plaque de fond (37) de la chambre (1) pouvant être mise sous vide.

6. Dispositif selon la revendication 2, caractérisé en ce que le dispositif conçu pour l'admission de substances gazeuses dans la chambre (1) pouvant être mise sous vide est constitué par un distributeur annulaire (23) comportant plusieurs chambres qui, de l'extérieur, peut être alimenté de gaz de réaction pouvant entrer librement dans l'enceinte de la chambre de réaction.

7. Dispositif selon la revendication 3, caractérisé en ce que le dispositif conçu pour l'admission de substances gazeuses dans la chambre (1) pouvant être mise sous vide est réalisé à l'aide de conduites d'alimentation de gaz (45) introduites de façon étanche au vide dans ladite chambre et débouchant dans l'autre alésage (15) qui s'étend perpendiculairement à l'alésage central (13) du bloc isolateur tout en débouchant dans celui-ci.

8. Dispositif selon la revendication 1, caractérisé en ce que, au moins, l'une des deux électrodes (l'électrode annulaire 5 et/ou l'électrode à plaque 3) est munie d'un plateau tournant (33) pouvant être tourné par une roue dentée (35) faisant corps avec l'électrode, qui peut être entraînée par une pièce intermédiaire électriquement isolante et à partir de l'extérieur par l'intermédiaire d'une traversée rotative (39) introduite de façon étanche au vide dans la chambre (1) pouvant être mise sous vide.

9. Dispositif selon les revendications 6, caractérisé en ce que le distributeur annulaire (23) comportant plusieurs chambres présente au moins un raccord (25) pour l'admission de gaz de processus à partir duquel (desquels) ils arrivent par l'intermédiaire des alésages dans des chambres (27) mutuellement reliées et situées dans le distributeur annulaire comportant plusieurs chambres, au-dessus du (des) raccord(s), à partir desdites chambres et par l'intermédiaire d'une multitude d'alésages (29) les gaz de processus entrent dans l'enceinte de réaction de la chambre (1) pouvant être mise sous vide située au-dessus du distributeur annulaire comportant plusieurs chambres pour être aspirés à nouveau de la chambre pouvant être mise sous vide à travers l'alésage central (11) percé dans l'électrode annulaire (5) et les alésages centraux (13, 19) percés dans le bloc isolateur.

10. Dispositif selon la revendication 1, caractérisé en ce que, au moins l'une des deux électrodes (l'électrode à plaque (3) (l'électrode annulaire 5) est munie d'un système de labyrinthe de tempérage (41) qui est relié à un système de recirculation de véhicule de tempérage par l'intermédiaire d'un bourrelet de raccordement (43) détachable.

11. Dispositif selon la revendication 1, caractérisé en ce que pour l'engendrement de la tension électrique est prévu un générateur HF muni de connexions pour l'électrode annaulaire (5) et/ou à l'électrode à plaque (3).

12. Dispositif selon les revendications 10 et 11, caractérisé en ce que le bourrelet de raccordement (43) fonctionne en même temps comme raccord pour le générateur HF.

13. Dispositif selon la revendication 7, caractérisé en ce que l'alésage central (11) percé dans l'électrode annulaire (5) et situé en face de l'enceinte de réaction, peut être couvert par une plaque perforée (47) par l'intermédiaire de laquelle les gaz de réaction entrent dans l'enceinte de réaction.

14. Dispositif selon la revendication 1, caractérisé en ce que les deux parties (7, 9, 99) du bloc isolateur sont en matériau électriquement isolant convenable pour l'utilisation HF.

15. Dispositif selon la revendication 14, caractérisé en ce que les deux parties (7, 9, 99) du bloc isolateur sont en polytétrafluoroéthylène.

16. Dispositif selon la revendication 1, caractérisé en ce que pour son déplacement axial, l'électrode à plaque (3) est relié par l'intermédiaire d'un isolateur à une traversée coulissante (55) pénétrant dans la chambre (1) de façon étanche au vide.

17. Dispositif selon la revendication 1, caractérisé en ce que des substrats peuvent être disposés sur l'électrode annulaire (5) aussi bien que sur l'électrode à plaque (3).

18. Dispositif selon les revendications 7 et 13, caractérisé en ce que la seconde partie (99) du bloc isolateur comporte des fentes (49) permettant l'aspiration des gaz de réaction par la pompe à vide.

19. Dispositif selon la revendication 8, caractérisé en ce qu'un lubrifiant à conduction thermique convenable permet d'améliorer les propriétés de glissement entre le(s) plateau(x) tournant(s) (33) et la (les) électrode(s) (électrode à plaque (3); (électrode annulaire (5).

20. Dispositif selon la revendication 1, caractérisé en ce que l'électrode annulaire (5) aussi bien que l'électrode à plaque (3) peuvent être munies de plaques chauffées par résistance fonctionnant comme chauffage d'appoint, la transmission de courant de chauffage ayant lieu par l'intermédiaire de contacts à bague glissante.

21. Dispositif selon la revendication 20, caractérisé en ce que des tôles de rayonnement (57) peuvent être montés entre le(s) plateau(x) tournant(s) (33) et la (les) plaque(s) chauffée(s) par résistance (53).

22. Dispositif selon les revendications 17 et 20, caractérisé en ce que des substrats peuvent être disposés sur les plaques chauffées par résistance (53).

23. Dispositif selon les revendications 1 à 22, caractérisé en ce que lorsque le dispositif est utilisé comme dispositif de pulvérisation cathodique à haute fréquence les électrodes peuvent être munies de blindages (51) reliés au potentiel de masse.

24. Procédé pour la formation d'une couche polymérisée par plasma sur un substrat en utilisant le dispositif selon les revendications 1 à 22, caractérisé en ce qu'au moins un substrat à revêtir est disposé sur l'une des deux électrodes (l'électrode à plaque (3) ou l'électrode annulaire (5)) disposées dans la chambre (1) pouvant être mise sous vide et en ce que par l'intermédiaire du dispositif d'alimentation de substances gazeuses, est admis dans ladite chambre un gaz de départ constitué au moins d'un gaz de processus monomère permettant de déposer une couche en matériau polymérisé par plasma sur le(s) substrat(s) par l'intermédiaire d'excitation à haute fréquence des molécules de phase gazeuse et, le cas échéant, un gaz porteur inerte.

25. Procédé selon la revendication 24, caractérisé en ce que la couche de matériau polymérisé par plasma est formée en sorte qu'est admis comme gaz de processus monomère, au moins, un tel gaz permettant la formation de composés polymérisés à teneur de Si:N:C:H.

26. Procédé selon la revendication 25, caractérisé en ce qu'on utilise de l'hexaméthyldisilazane comme gaz de processus monomère.
